# EUROPEAN PATENT APPLICATION

(11) **EP 4 826 446 A1**
(43) Date of publication of application: **21.10.2026**
(21) Application number: 25190132.8
(22) Date of filing: 17.07.2025
(51) Int. Cl.: G03F 1/26

(54) **PHASE SHIFT BLANKMASK AND PHOTOMASK FOR EUV LITHOGRAPHY**

(30) Priority: 15.04.2025 KR 20250048515
(71) Applicant: S&S Tech Co., Ltd., Daegu 42714 (KR)
(72) Inventor: YUN, Jong-Won, KR-42714 Dalseo-gu (KR); PARK, Min-Kyu, KR-42714 Dalseo-gu (KR); WOO, Mi-Kyung, KR-42714 Dalseo-gu (KR); YANG, Chul-Kyu, KR-42714 Dalseo-gu (KR); KIM, Yong-Dae, KR-42714 Dalseo-gu (KR)
(74) Representative: ABG Intellectual Property Law, S.L.

(57) **Abstract**

A phase shift blankmask for EUV lithography includes a phase shift film, and the phase shift film has a first layer and a second layer. The first layer contains tantalum (Ta), has a Ta content exceeding 50at%, and has an extinction coefficient (k) exceeding 0.030. The second layer contains chromium (Cr) and niobium (Nb), has a total content of Cr and Nb exceeding 50at%, has a composition ratio of Cr:Nb = 6.3:3.7 - 3.7:6.3, and has an extinction coefficient (k) exceeding 0.020. The phase shift film has an effective extinction coefficient (eff. k) exceeding 0.022 for an EUV wavelength of 13.5nm, and has a relative reflectance of less than 8% for an EUV wavelength of 13.5nm. Since the phase shift film uses CrNb as the main material, it has various advantages such as low surface roughness and good etching characteristics of this material. Additionally, despite the high reflectance of CrNb material, it is possible to implement a relative reflectance of less than 8% even with a small thickness.

## Description

### CROSS-REFERENCE TO RELATED APPLICATIONS

This application is based on and claims priority under 35 U.S.C. §119 to Korean Patent Application No. 10-2025-0048515 filed on April 15, 2025 in the Korean Intellectual Property Office, the disclosure of which is incorporated by reference herein in its entirety.

### BACKGROUND

### Field

The present invention relates to a blankmask and a photomask for EUV lithography, having a phase shift film.

### Description of the Related Art

Recent lithography technology for semiconductor manufacturing has been advancing from ArF, ArFi MP(Multiple) Lithography to EUV Lithography technology. EUV Lithography technology uses a 13.5nm exposure wavelength, enabling improved resolution and process simplification, making it a prominent technology for manufacturing semiconductor devices below 10nm. EUV lithography uses reflective type photomasks with a reflective optical system.

The blankmask serves as the raw material for the photomask, which comprises two films on a substrate: a reflective film that reflects EUV light and an absorber film that absorbs EUV light. The photomask is manufactured by patterning the absorber film of this blankmask, utilizing the contrast difference between the reflectance of the reflective film and the absorber film to form patterns on the wafer.

Recently, there is a demand for developing blankmasks for semiconductor devices below 10nm, specifically 7nm, 5nm, and even below 3nm. However, in processes below 5nm, such as 3nm processes, using current binary photomasks would require Double Patterning Lithography (DPL) technology. Accordingly, the development of phase shift blankmasks, which can achieve higher resolution compared to binary blankmasks with absorber films, is being attempted.

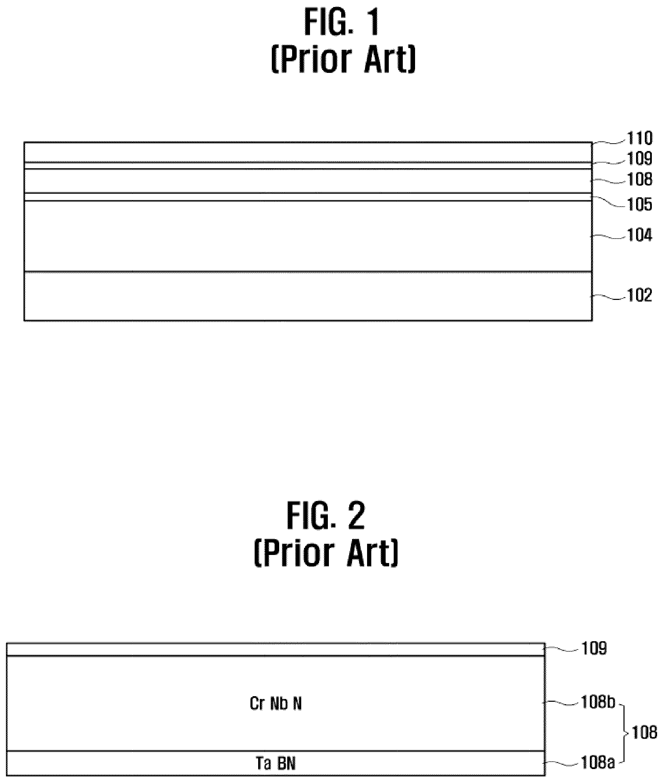

FIG. 1 illustrates the basic structure of a phase shift blankmask for extreme ultraviolet lithography. The phase shift blankmask for extreme ultraviolet lithography consists of a substrate 102, a reflective film 104 formed on the substrate 102, a capping film 105 formed on the reflective film 104, a phase shift film 108 formed on the capping film 105, a hard mask film 109 formed on the phase shift film 108, and a resist film 110 formed on the hard mask film 109. In this structure of an EUV lithography phase shift blankmask, the phase shift film 108 is preferably made with materials that facilitate photomask fabrication and provide excellent performance during wafer printing. Additionally, the phase shift film 108 must meet the requirements for various properties such as reflectance.

As an example of a preferred configuration of the phase shift film 108, the applicant of this invention previously filed Korean Patent Application No. 2021-0077682 (Phase Shift Blankmask and Photomask for Extreme Ultraviolet Lithography). FIG. 2 illustrates the configuration of the phase shift film 108 proposed in this patent application, along with the hard mask film 109 above the phase shift film 108.

In FIG. 2, the phase shift film 108 has a two-layer structure, with a first layer 108a formed above the reflective film 104 and a second layer 108b formed above the first layer 108a. The second layer 108b is composed of CrNbN. Specifically, the second layer 108b has a composition ratio of Cr:Nb:N = 30-40at%:20-50at%:10-50at%. The second layer 108b has a thickness of 30-40nm. The first layer 108a is composed of TaBN. The first layer 108a functions to prevent oxidation of Ru, which constitutes the capping film 105, by chlorine-based etching gas used for etching the second layer 108b. The first layer 108a also functions to control the overall reflectance and phase shift amount of the phase shift film 108. For this purpose, the composition ratio and thickness of the materials constituting the first layer 108a can be adjusted variously. The first layer 108a has the minimum thickness required for reflectance control, preferably a thickness of 7nm or less. The phase shift film 108 in FIG. 2 has a relative reflectance of 9-15% and a phase shift amount of 170-230°.

Prior to the invention in the above-mentioned patent application, tantalum (Ta) was mainly used as the material for the phase shift film 108, but such a phase shift film 108 has very low reflectance with a relative reflectance of 5% or less, making it difficult to achieve high wafer printing effects. By having the phase shift film 108 adopt a configuration where CrNb is the main material thereof, as in the above-mentioned patent application, it is possible to implement higher reflectance compared to Ta-based phase shift films. Additionally, CrNb phase shift film 108 provides various advantages such as etching using chlorine gas (Cl₂) and low surface roughness. Also, Nb has a lower refractive index compared to Ta, providing the advantage of easily implementing the required phase shift amount for the phase shift film 108.

Generally, higher reflectance of the phase shift film 108 improves wafer printing performance. However, for random patterns with low repetition and low symmetry, as in logic applications, excessively high reflectance is not desirable due to sidelobe effects, and generally, the relative reflectance should be less than 8%. To meet the reflectance limitation while using CrNb as the main material, the thickness of the phase shift film 108 must be very thick, over 60nm. However, in EUV lithography photomasks, the EUV exposure light enters at an angle of 6-7° from the direction perpendicular to the substrate 102, so if the phase shift film 108 is too thick, the precision of the exposed pattern deteriorates due to the shadowing effect. Therefore, a solution is needed for CrNb-based phase shift films 108 to have a thin thickness while meeting the reflectance limitation.

### SUMMARY

The present invention was devised to solve the aforementioned problems. The purpose of this invention is to provide an EUV blankmask with a phase shift film that has the advantages of using CrNb as the main material, while also preventing thickness increase while suppressing the reflectance from being excessively high.

The present invention provides a phase shift blankmask for extreme ultraviolet lithography comprising: a substrate; a reflective film formed on the substrate; a capping film formed on the reflective film; and a phase shift film formed on the capping film. The phase shift film has a first layer formed on the capping film and a second layer formed on the first layer. The first layer includes tantalum (Ta), has a Ta content exceeding 50at%, and has an extinction coefficient (k) exceeding 0.030. The second layer includes chromium (Cr) and niobium (Nb), has a total content of Cr and Nb exceeding 50at%, has a composition ratio of Cr:Nb = 6.3:3.7 - 3.7:6.3, and has an extinction coefficient (k) exceeding 0.020. The phase shift film has an effective extinction coefficient (eff. k) exceeding 0.022 for an EUV wavelength of 13.5nm in an entire film including the first layer and the second layer, and has a relative reflectance of less than 8% for an EUV wavelength of 13.5nm.

The phase shift film has a relative reflectance exceeding 5%.

The second layer can have a composition ratio of Cr:Nb = 4.3:5.7 - 3.7:6.3. In this case, the first layer has a thickness exceeding 8nm and less than 21nm. Preferably, the first layer has a thickness exceeding 8nm and less than 13nm, and more preferably, has a thickness exceeding 8nm and less than 10nm. The sum of a thicknesses of the first layer and the second layer is 55.5±1.5nm.

The second layer can have a composition ratio of Cr:Nb = 6.3:3.7 - 5.7:4.3. In this case, the first layer has a thickness exceeding 2nm and less than 21nm. Preferable, the first layer has a thickness exceeding 2nm and less than 13nm, and more preferably, has a thickness exceeding 2nm and less than 5nm. The sum of a thicknesses of the first layer and the second layer is 49.5±1.5nm.

The phase shift blankmask according to the present invention can further comprise a hard mask film formed on the phase shift film, including tantalum (Ta) and oxygen (O), having a Ta content of less than 50at%, and having an extinction coefficient (k) exceeding 0.020. The hard mask film has a thickness of 2±1nm.

According to another aspect of the present invention, a photomask fabricated using the phase shift blankmask for extreme ultraviolet lithography is provided.

According to the present invention, since the phase shift film uses CrNb as the main material, it has various advantages such as low surface roughness and good etching characteristics of this material. Additionally, despite the high reflectance of CrNb material, it is possible to implement a relative reflectance of less than 8%, so there is no need to increase the thickness to meet the reflectance limitation. Accordingly, both sidelobe effect and shadowing effect can be prevented. Using a photomask made with this blankmask, excellent resolution can be achieved when fabricating patterns below 7nm.

### BRIEF DESCRIPTION OF THE DRAWINGS

FIG. 1 is a diagram illustrating the basic structure of a phase shift blankmask for extreme ultraviolet lithography.
FIG. 2 is a diagram illustrating a detailed configuration of the phase shift film in FIG. 1, showing an example of the configuration proposed in Korean Patent Application No. 2021-0077682.
FIG. 3 is a diagram illustrating the change in reflectance according to the thickness of the film containing Cr:Nb = 4:6 composition ratio.
FIG. 4 is a diagram illustrating the change in reflectance with respect to the thickness of the second layer in a phase shift film composed of a first layer containing Ta and a second layer containing Cr:Nb = 4.3:5.7 - 3.7:6.3 according to the first embodiment of this invention.
FIG. 5 is a diagram illustrating the change in reflectance of the phase shift film with respect to the thickness of the second layer in a case where the first layer is thicker than in FIG. 4.
FIG. 6 is a graph illustrating the change in reflectance according to the thickness of each layer of the phase shift film, divided into sections for each period.
FIG. 7 is a graph showing the NILS measured in the horizontal direction of the phase shift film.
FIG. 8 is a graph showing the NILS measured in the vertical direction of the phase shift film.
FIG. 9 to FIG. 11 are diagrams similar to FIG. 6 to FIG. 8, respectively, illustrating the change in reflectance according to the thickness of the phase shift film composed of a first layer containing Ta and a second layer containing Cr:Nb = 6.3:3.7 - 5.7:4.3 according to the second embodiment of the present invention.

### DETAILED DESCRIPTION OF EXEMPLARY EMBODIMENTS

The blankmask of this invention has the same basic film structure as the blankmask in FIG. 1. Therefore, in the following description of this invention, redundant explanations for configurations already explained with reference to FIG. 1 will be omitted, and such explanations are incorporated as descriptions of the basic configuration of this invention. Further, when comparing the phase shift film of this invention with the phase shift film 108 in FIG. 2, the stacked constitution of the films and the composition materials of each film are identical, with differences in detailed configurations such as composition ratios or thicknesses. Therefore, specific explanations for configurations already shown and explained in FIG. 2 that are identical to this invention will be omitted, and the following description will focus on the unique configurations of this invention. In the following description of this invention, the same reference numerals used in FIG. 1 and FIG. 2 are cited for the same components for convenience of explanation.

As shown in FIG. 1 and FIG. 2, the blankmask of this invention includes a substrate 102, a reflective film 104, a capping film 105, and a phase shift film 108. A hard mask film 109 is formed on the phase shift film 108.

The phase shift film 108 of this invention has a relative reflectance of less than 8%, and preferably has a relative reflectance exceeding 5%. Here, the relative reflectance refers to the ratio of the absolute reflectance of the phase shift film 108 compared to the absolute reflectance of the reflective film 104 including the capping film 105. In the following description, "reflectance" refers to relative reflectance. The phase shift film 108 has a phase shift amount of 1-1.3π, and preferably has a phase shift amount of 1-1.2π, for example, which maximizes the effect of NILS (Normalized Image Log Slope) during Wafer Printing.

To implement such reflectance, the phase shift film 108 of this invention is configured to have an effective extinction coefficient (eff. k) exceeding 0.022 in the entire film. Here, the effective extinction coefficient (eff. k) is obtained by the following formula, for example, when the phase shift film 108 is composed of a two-layer film structure including a first layer 108a and a second layer 108b: $eff . k = \left(k1*t1+k2*t2\right) / \left(t1+t2\right)$
k1, k2: extinction coefficients of the first and second layers
t1, t2: thicknesses of the first and second layers

The composition materials of each layer of the phase shift film 108, the composition ratios of each composition material, and the thickness of each layer are controlled to satisfy the ranges of such reflectance, phase shift amount, and effective extinction coefficient (eff. k).

The phase shift film 108 of this invention has a first layer 108a formed on the capping film 105 and a second layer 108b formed on the first layer 108a. The first layer 108a includes tantalum (Ta), and the second layer 108b includes chromium (Cr) and niobium (Nb). The first layer 108a may additionally include one or more of boron (B) and nitrogen (N) besides Ta, and the second layer 108b may additionally include one or more of boron (B), oxygen (O), and nitrogen (N) besides CrNb. These light elements function to adjust various physical properties required for the first layer 108a and the second layer 108b.

The second layer 108b of the phase shift film 108 of this invention is configured to have a composition ratio range of Cr:Nb = 6.3:3.7 - 3.7:6.3. When etching the phase shift film 108, it is preferable to use an etching gas containing only chlorine (Cl₂) without oxygen (O₂) to prevent oxidation of the capping film 105 below. To secure sufficient etching speed in an etching gas containing only chlorine (Cl₂), it is preferable that the content of Cr be lower than Cr:Nb = 6.3:3.7. In CrNb alloys, as Cr increases, the etching speed slows down, and as Nb increases, damage to the cleaning solution (SPM) increases and the extinction coefficient (k) decreases. If the content of Nb is higher than Cr:Nb = 3.7:6.3, the extinction coefficient (k) decreases excessively, making it difficult to satisfy the range of effective extinction coefficient (eff. k) as mentioned above.

As explained in the description of the prior art, for cases close to random pattern repetition and random symmetry, such as logic applications, the relative reflectance of the phase shift film 108 is preferably less than 8% to prevent sidelobe effects. In that situation, to satisfy this reflectance limitation with only the second layer 108b having the composition ratio of CrNb as described above, the thickness of the second layer 108b must be 60nm or more, which would cause a decrease in pattern precision due to the shadowing effect. Therefore, by forming the first layer 108a with a material containing Ta, which has a higher extinction coefficient (k) compared to CrNb, the effective extinction coefficient (eff. k) of the entire phase shift film 108 can be increased, thereby decreasing the overall thickness of the phase shift film 108.

Preferably, the first layer 108a has an extinction coefficient (k) exceeding 0.030, and the second layer 108b has an extinction coefficient (k) exceeding 0.020. Since the first layer 108a includes Ta, which has a higher extinction coefficient (k) compared to the alloy of Cr and Nb, it can have a higher extinction coefficient (k) compared to the second layer 108b. As the first layer 108a has a much higher extinction coefficient (k) than the second layer 108b, as in the above range, the overall extinction coefficient (k) of the phase shift film 108 can be increased even with a slight increase in the thickness of the first layer 108a. The extinction coefficient (k) decreases as the content of light elements such as nitrogen (N), oxygen (O), and boron (B) increases, and increases as the content of metals increases. To satisfy the above range of extinction coefficients (k) for the first layer 108a and the second layer 108b, it is preferable that the first layer 108a is configured to have a Ta content exceeding 50at%, and the second layer 108b is configured to have a total content of Cr and Nb exceeding 50at%.

The hard mask film 109 is used as a mask for etching the phase shift film 108 after being patterned by the resist film 110. The hard mask film 109 is not an essential film and is formed optionally as needed. However, for the efficiency of the etching process of the phase shift film 108, it is generally preferable to have a hard mask film 109. Since the phase shift film 108 containing CrNb is etched by chlorine-based etching gas, the hard mask film 109 is formed of a material that is etched by fluorine-based etching gas. As an example, this invention illustrates that the hard mask film 109 is composed of a film containing tantalum (Ta) and oxygen (O). Tantalum (Ta) is etched by chlorine-based etching gas when it does not contain oxygen (O), but when it contains oxygen (O), it is etched by fluorine-based etching gas. The hard mask film 109 may additionally include one or more of boron (B) and nitrogen (N). For example, the hard mask film 109 can be formed of one of TaO, TaON, TaOB, or TaOBN. Such a hard mask film 109 has a minimum thickness that can perform the etching mask function, and preferably has a thickness of less than 5nm, more preferably a thickness of 2±1nm.

For the TaO hard mask film 109 to have good etching characteristics against fluorine-based etching gas, the oxygen (O) content must be high, and accordingly, the Ta content must be reduced. Preferably, to secure sufficient etching performance, it is configured so that the Ta content is less than 50at%. In this case, the extinction coefficient (k) of the hard mask film 109 becomes similar to that of the second layer 108b. Therefore, in the viewpoint of the extinction coefficient (k), the hard mask film 109 functions similarly to the phase shift film 108. Preferably, the hard mask film 109 is configured to have an extinction coefficient (k) exceeding 0.020.

The hard mask film 109 is generally removed after the etching of the phase shift film 108 is completed, but in some cases, it remains without being removed and is used as part of the pattern in the photomask. That is, after the etching of the phase shift film 108 is completed, unless an additional etching process using fluorine (F)-based gas is performed, the hard mask film 109 remains on top of the phase shift film 108 after the photomask fabrication is completed. In this case, the hard mask film 109 also functions as part of the phase shift film 108, resulting in an increase in the thickness of the phase shift film 108 by the thickness of the hard mask film 109.

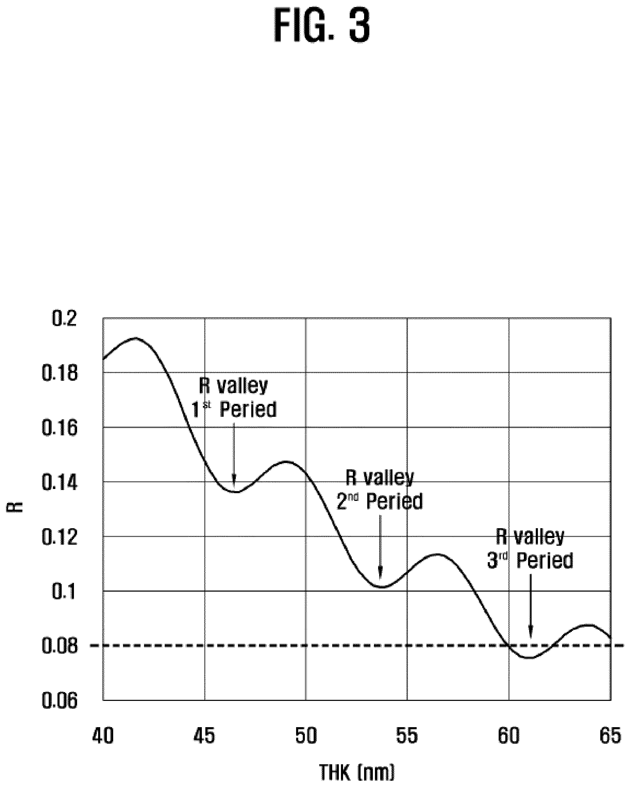

In the following description referring to FIG. 3 to FIG. 11 for this invention, the results were tested with a hard mask film 109 containing TaO and having a thickness of 2nm formed on top of the phase shift film 108. That is, the following description of this invention assumes that the pattern of the hard mask film 109 containing TaO and having a thickness of 2nm remains in the photomask. Accordingly, in the following description, when referring to the properties of the entire stacked structure 108 and 109 of the phase shift film 108 and the hard mask film 109, it is expressed as "reflectance of the stacked structure 108 and 109", "extinction coefficient of the stacked structure 108 and 109", "NILS of the stacked structure 108 and 109", and so on. Expressions simply written as "reflectance", "extinction coefficient", "NILS" refer to the respective properties in the stacked structure 108 and 109 in the description of embodiments including the hard mask film 109, and refer merely to the respective properties in the phase shift film 108 in the description of embodiments not including the hard mask film 109.

The following examines the specific details for deriving the detailed configuration of the phase shift film 108 of this invention based on the technical concept described above.

FIG. 3 is a diagram illustrating the change in relative reflectance according to the thickness of a film containing a composition ratio of Cr:Nb = 4:6. The film containing CrNb corresponds to the film of the second layer 108b of the phase shift film 108 in this invention. In FIG. 3, the horizontal axis represents the thickness of the CrNb film, and the vertical axis represents the reflectance of the stacked structure of the CrNb film and a 2nm thick TaO film. As the thickness of the CrNb film increases, the reflectance decreases, but the overall change shows a pattern of decreasing in the form of a wave with a period of about 7nm, which is the half-wavelength (λ/2) of the 13.5nm wavelength EUV exposure light. As can be seen from FIG. 3, for the reflectance to be less than 8%, the CrNb film must have a thickness of at least 60nm or more, resulting in the sum of the thicknesses of the CrNb film and the TaO film becoming very thick, at least 62nm or more.

Also, as shown in FIG. 3, the valleys in the reflectance graph for the EUV wavelength repeat at a period of about 7nm, which is the half-wavelength (λ/2). Therefore, if the valley satisfying less than 8% reflectance is shifted to the left by one period by including a first layer 108a with Ta as the main material to compensate for the insufficient extinction coefficient (k), the thickness of the film can be reduced by about 7nm. Similarly, if the valley satisfying less than 8% reflectance is shifted to the left by n periods by the first layer 108a, the thickness of the film can be reduced by 7*n(nm).

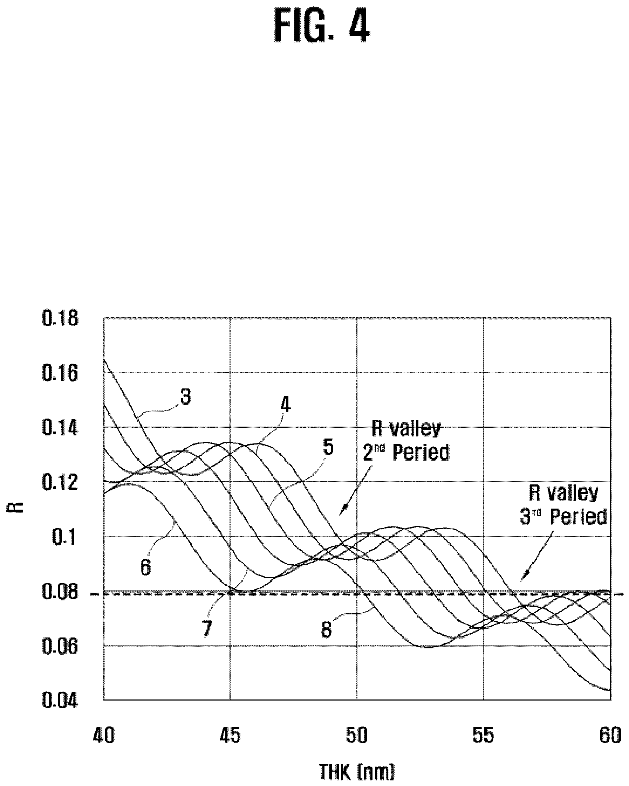

FIG. 4 to FIG. 8 are diagrams specifically explaining the first embodiment of this invention. The first embodiment of this invention was implemented with the goal of forming the second layer 108b with a material containing a composition ratio of Cr:Nb = 4:6. However, this first embodiment also applies to cases where the second layer 108b has a composition ratio of Cr:Nb = 4.3:5.7 - 3.7:6.3, which includes the composition ratio of Cr:Nb = 4:6, and substantially the same results are obtained within this range. When actually implementing a film with a composition ratio of Cr:Nb = 4:6, a film with a range of Cr:Nb = 4.3:5.7 - 3.7:6.3 is obtained due to manufacturing process tolerances. The first embodiment was configured to satisfy the requirements of this invention as described above in terms of the composition of each layer, extinction coefficient (k), and other properties.

FIG. 4 is a diagram illustrating the change in reflectance with respect to the thickness of the second layer 108b in a phase shift film 108 composed of a first layer 108a containing Ta and a second layer 108b containing a composition ratio of Cr:Nb = 4.3:5.7 - 3.7:6.3 according to the first embodiment of this invention.

In FIG. 4, the horizontal axis (THK) represents the thickness of the second layer 108b, and the vertical axis (R) represents the reflectance of the stacked structure 108 and 109. Specifically, FIG. 4 shows the change in reflectance of the stacked structure 108 and 109 for each case where the thickness of the first layer 108a is configured as 3nm, 4nm, 5nm, 6nm, 7nm, and 8nm, in a manner similar to FIG. 3. Figure 4 shows six graphs, and the reference numerals assigned to respective graphs represent the thickness of the first layer (108a). For example, the graph to which the reference numeral 8 is assigned shows the relative reflectance of the stacked structure 108 and 109 when the thickness of the second layer 108b varies in the range of 40-60nm with the first layer 108a configured with a thickness of 8nm. In the following description, the graph with reference numeral n is referred to as "graph n."

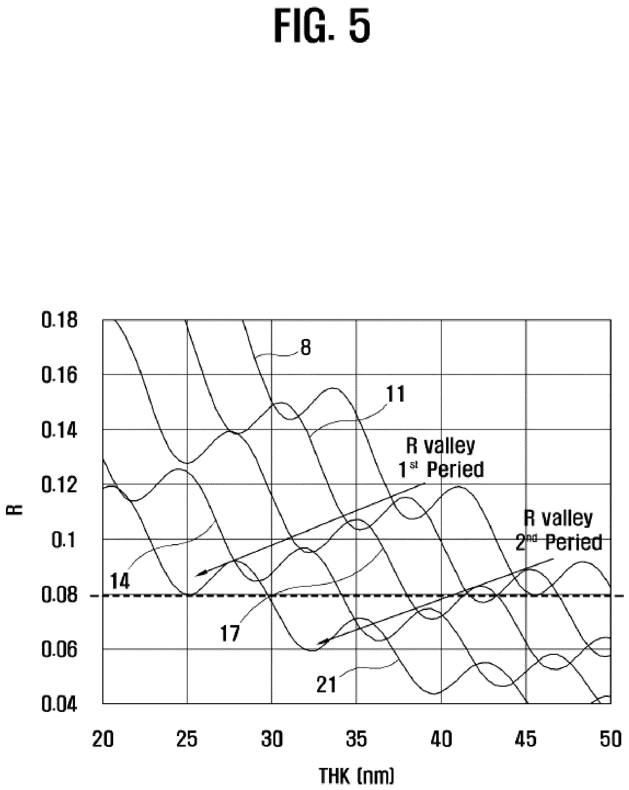

FIG. 5 is a diagram illustrating the change in reflectance of the stacked structure 108 and 109 with respect to the thickness of the second layer 108b in cases where the first layer 108a is thicker than in the case of FIG. 4. Specifically, FIG. 5 shows the change in reflectance for each case where the thickness of the first layer 108a is 8nm, 11nm, 14nm, 17nm, and 21nm, in a manner similar to FIG. 4. The graph 8 in FIG. 5 is the same graph as the graph 8 in FIG. 4, i.e., the graph for the case where the thickness of the first layer 108a is 8nm, and the graph 21 is the graph for the case where the thickness of the first layer 108a is 21nm.

Referring to the graphs in FIG. 4 and FIG. 5, it can be seen that, as in the case of FIG. 3, reflectance valleys are repetitively formed approximately every 7nm, which is the half-wavelength (λ/2) period. Also, the thicker the first layer 108a, the more the reflectance graph shifts to the left. Therefore, the thicker the first layer 108a, the more a relative reflectance of less than 8% can be implemented even with a thinner thickness of the second layer 108b.

In the thickness range of the second layer 108b corresponding to 3rd period, the phase shift film 108 is too thick, causing shadowing effect problems. Therefore, looking for positions where a relative reflectance of less than 8% is implemented in the 1st or 2nd period in FIG. 4 and FIG. 5, in the case of the graph 8 in FIG. 4 and FIG. 5, i.e., when the thickness of the first layer 108a is 8nm, a reflectance of less than 8% is obtained at the point where the thickness of the second layer 108b is 46±1nm. Looking at FIG. 4, when the thickness of the first layer 108a is less than 8nm, a reflectance of less than 8% is not obtained in the 2nd period and can only be obtained in the 3rd period. Therefore, it can be seen that to obtain a reflectance of less than 8% in the 2nd period range, the thickness of the first layer 108a must exceed at least 8nm. Also, as can be seen from FIG. 5, when the thickness of the first layer 108a exceeds 8nm, the thickness range of the second layer 108b where a reflectance of less than 8% can be obtained gradually increases, and for example, when the thickness of the first layer 108a is 21nm, i.e., in the graph 21, a reflectance of less than 8% is obtained in all ranges where the thickness of the second layer 108b is greater than 30nm. In summary, for the stacked structure 108 and 109 to have a relative reflectance of less than 8% while having a thin thickness that does not cause shadowing effect problems, the thickness of the first layer 108a must exceed at least 8nm.

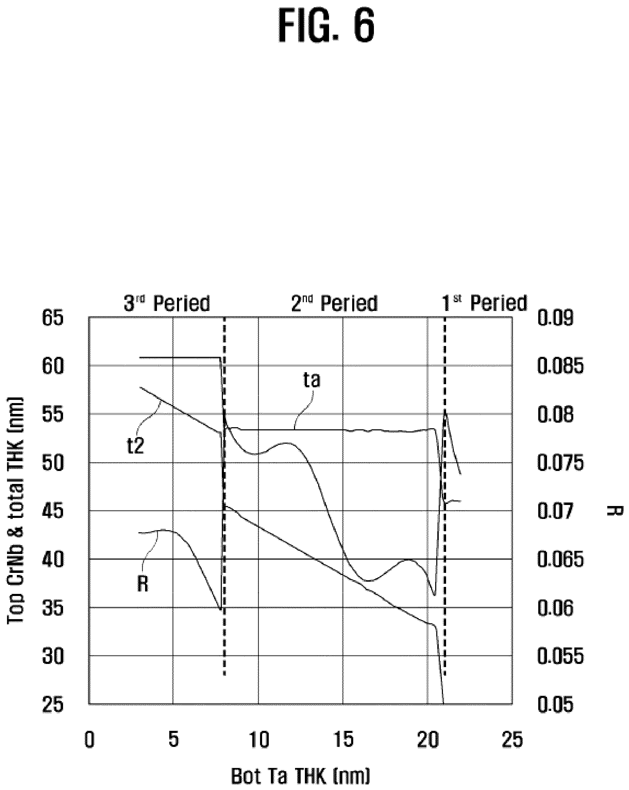

On the other hand, considering only the aspect of reducing the thickness of the stacked structure 108 and 109 to prevent shadowing effect, it would be preferable for the thickness of the first layer 108a to be thicker, as can be seen from FIG. 5. However, if the thickness of the first layer 108a increases excessively, it becomes difficult to meet the minimum NILS requirement for the stacked structure 108 and 109. Specifically, in the graph 21 in FIG. 5, corresponding to the case where the first layer 108a has a thickness of 21nm, a relative reflectance of less than 8% can be obtained as long as the thickness of the second layer 108b is at least 30nm, so the stacked structure 108 and 109 can be made very thin while still meeting the relative reflectance requirement. However, at this thickness, the NILS requirement of 2.0 or higher required for process efficiency is not met. The following section examines in more detail the thickness of each layer 108a and 108b for meeting the NILS requirement, with reference to FIG. 6 to FIG. 8.

FIG. 6 is a graph illustrating the change in reflectance according to the thickness of each layer 108a and 108b of the phase shift film 108, divided into sections for each period.

In FIG. 6, the vertical axis shows both the total thickness of the phase shift film 108 (the graph labeled as "total THK" on the left side of the vertical axis in FIG. 6, and assigned with reference numeral ta) and the thickness of the second layer 108b (the graph labeled as "Top CrNb" on the left side of the vertical axis in FIG. 6, and assigned with reference numeral t2). Also, in FIG. 6, the vertical axis shows the reflectance of the stacked structure 108 and 109 (the graph labeled as "R" on the right side of the vertical axis in FIG. 6, and assigned with reference numeral R). The horizontal axis in FIG. 6 is the thickness of the first layer 108a (labeled as "Bot Ta THK" in FIG. 6). In FIG. 6, the 1st period, 2nd period, and 3rd period correspond to the 1st period, 2nd period, and 3rd period shown in FIG. 4 and FIG. 5, respectively.

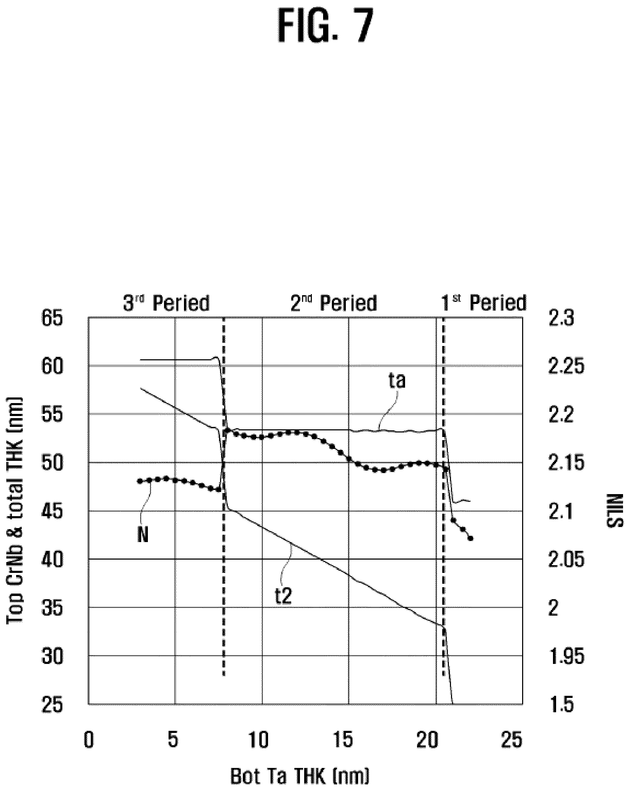

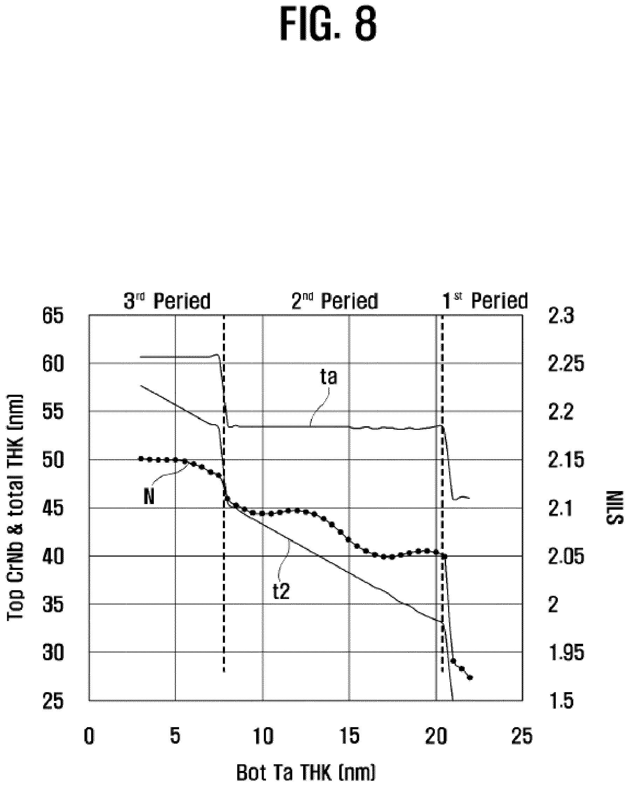

FIG. 7 and FIG. 8 are graphs similar to FIG. 6, showing NILS instead of reflectance (R) in FIG. 6. That is, the vertical axis in FIG. 7 and FIG. 8 (the graph labeled as "NILS" on the right side of the vertical axis in FIG. 7 and FIG. 8, and assigned with reference numeral N) shows the NILS of the stacked structure (108 and 109). Here, FIG. 7 shows the NILS measured in the horizontal direction of the stacked structure 108 and 109, and FIG. 8 shows the NILS measured in the vertical direction of the stacked structure 108 and 109. Here, the horizontal direction means the direction in which the pattern of the phase shift film 108 is parallel to the inclined direction of the incident exposure light, i.e., the direction in which the shadowing effect is small, and the vertical direction means the direction in which the pattern of the phase shift film 108 is perpendicular to the inclined direction of the incident exposure light, i.e., the direction in which the shadowing effect is large.

In each graph in FIG. 6 through FIG. 8, the total thickness ta of the phase shift film 108 for each period consists of the optimal thickness combination of the first layer 108a and the second layer 108b. Here, the optimal thickness refers to the thickness at which NILS is optimized in FIG. 7 and FIG. 8, and more precisely, it means the thickness at which the NILS value itself is high, while the changes in NILS, dose, and reflectance according to the thickness change of the phase shift film 108 are low. Specifically, if the thickness (t2) of the second layer 108b is selected to obtain the optimal NILS according to the numerical change of the thickness of the first layer 108a, which is the horizontal axis of FIG. 7 and FIG. 8, the result is that the NILS value is optimized when the sum (ta) of the thickness of the first layer 108a (Bot Ta THK) and the thickness of the second layer 108b (t2) is maintained constant. That is, for the optimized NILS value to be obtained, the total thickness (ta) of the phase shift film 108 must remain constant, and the second layer 108b must become thinner as the first layer 108a becomes thicker. This was confirmed by the results of testing while varying the thickness (t2) of the second layer 108b in various ways.

As shown in FIG. 7 and FIG. 8, the sum (ta) of these optimal thicknesses differs for each period and changes abruptly in a stepwise manner at the boundary of each period. From FIG. 7 and FIG. 8, it can be seen that the sum (ta) of the optimal thicknesses is 61±1.5nm in the 3rd period and 53.5±1.5nm in the 2nd period. In summary, in the 2nd period, the optimal NILS is obtained when the sum (ta) of the thicknesses of the first layer 108a and the second layer 108b is 53.5±1.5nm.

FIG. 6 to FIG. 8 show the reflectance (R) and NILS of the stacked structure 108 and 109 measured while changing the thickness (Bot Ta THK) of the first layer 108a, after deriving the value of the total THK (ta) in each period in consideration of the NILS optimization aspect.

First, referring to FIG. 6 showing the reflectance (R), in the 3rd period section where the first layer 108a has a thickness of 8nm or less, the reflectance (R) gradually decreases as the thickness of the first layer 108a increases, and the reflectance (R) is less than 8% across the entire range. However, since the total THK (ta) is 61±1.5nm, there is a problem of shadowing effect.

In the 2nd period section where the first layer 108a has a thickness exceeding 8nm, the reflectance (R) gradually decreases in a wave form as the thickness of the first layer 108a increases, and the reflectance (R) is less than 8% across the entire range. And in this case, since the total THK (ta) is 53.5±1.5nm, the total thickness of the stacked structure 108 and 109 including the thickness of the hard mask film 109 of 2nm is less than 60nm, so there is no problem of shadowing effect.

In the 1st period section where the first layer 108a has a thickness of 21nm or more, the reflectance (R) rises sharply around 21nm, but the reflectance (R) is less than 8% across the entire range substantially.

In summary, considering the reflectance (R) and shadowing effect problem, it can be seen that the thickness of the first layer 108a is required to exceed 8nm, which is the same result as examined through FIG. 4 and FIG. 5.

Referring to FIG. 7 and FIG. 8, it can be seen that the NILS values in the horizontal and vertical directions show good values of 2.0 or more across the entire range of the 2nd period section where the first layer 108a has a thickness exceeding 8nm. However, it can be seen that the NILS deteriorates sharply at thicknesses of 21nm or more, which is the 1st period section. Therefore, considering NILS, the thickness of the first layer 108a is preferably less than 21nm.

In the case of the NILS value in the vertical direction shown in FIG. 8, it shows high values up to the range where the thickness (Bot Ta THK) of the first layer 108a is less than 13nm, and begins to decrease from the section where it is 13nm or more. Therefore, in cases where a photomask requiring high NILS values must be manufactured, the thickness (Bot Ta THK) of the first layer 108a is preferably less than 13nm.

In summary, as examined through FIG. 6 to FIG. 8, to obtain a thinned phase shift film 108 that satisfies both the requirement of a relative reflectance (R) of less than 8% for the stacked structure 108 and 109 and the requirement of NILS of 2.0 or more, while having no shadowing effect problem, the thickness (Bot Ta THK) of the first layer 108a is preferably more than 8nm and less than 21nm, and at this situation, the sum (ta) of the thicknesses of the first layer 108a and the second layer 108b is preferably 53.5±1.5nm. Furthermore, for the production of a blankmask to be applied to a process requiring an even better NILS value in this case, the thickness (Bot Ta THK) of the first layer 108a is preferably more than 8nm and less than 13nm.

Meanwhile, in a phase shift film 108 with a two-layer structure, if both layers have a thickness of 10nm or more, a step-like difference may occur after etching for patterning the phase shift film 108. Therefore, if a case requires a pattern of higher precision by preventing the level difference of the phase shift film 108 pattern, it is preferable that at least one of the layers has a thickness of less than 10nm. Considering this point as well, it is preferable that the first layer 108a is configured to have a thickness of greater than 8nm and less than 10nm.

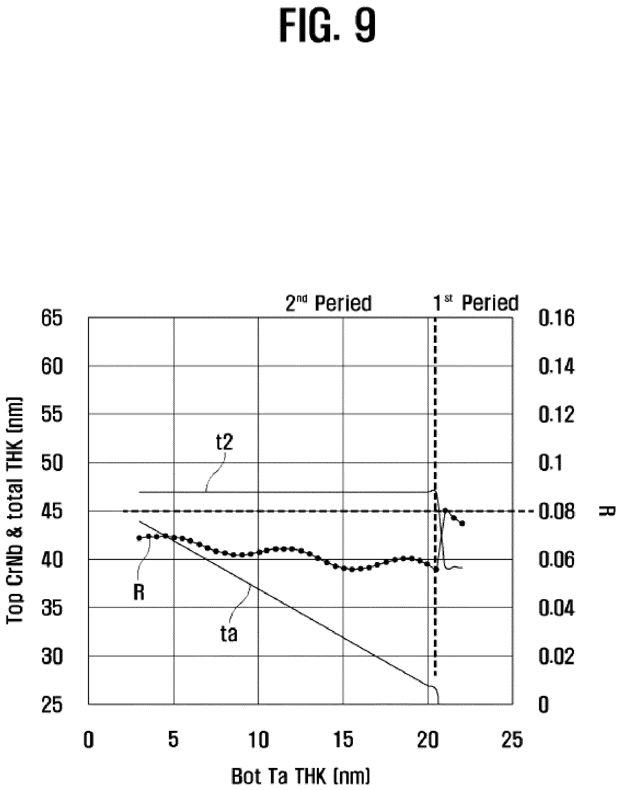

FIG. 9 to FIG. 11 are diagrams specifically explaining the second embodiment of this invention. The second embodiment of this invention was implemented with the goal of forming the second layer 108b with a material containing a composition ratio of Cr:Nb = 6:4. However, this second embodiment also applies to cases where the second layer 108b has a composition ratio of Cr:Nb = 6.3:3.7 - 5.7:4.3, which includes the composition ratio of Cr:Nb = 6:4, and substantially the same results are obtained within this range. When actually implementing a film with a composition ratio of Cr:Nb = 6:4, a film with a range of Cr:Nb = 6.3:3.7 - 5.7:4.3 is obtained due to manufacturing process tolerances. FIG. 9 to FIG. 11 are diagrams created in a manner similar to FIG. 6 to FIG. 8, respectively, for the phase shift film 108 of the second embodiment. The second embodiment was also configured to satisfy requirements for the physical properties such as the composition, extinction coefficient (k) of each layer, etc. as described above.

Cr has a higher extinction coefficient (k) compared to Nb. Therefore, since the composition of Cr:Nb = 6:4 in the second embodiment has a higher extinction coefficient (k) compared to the composition of Cr:Nb = 4:6 in the first embodiment, even if the thickness of the first layer 108a containing Ta is thinner than in the case of the first embodiment, it can easily achieve a reflectance of less than 8% by satisfying the range of effective extinction coefficient (eff. k) of this invention. Additionally, since the extinction coefficient (k) of the second layer 108b is high, the 3rd period does not need to be considered in the second embodiment. Accordingly, as shown in FIG. 9 to FIG. 11, the 3rd period is not shown in the second embodiment. According to the results of testing the optimal thickness in the 2nd period considering NILS optimization in the second embodiment, the preferable sum ta of the thicknesses of the first layer 108a and the second layer 108b is 47.5±1.5nm.

As shown in FIG. 9, in the second embodiment, the reflectance of the stacked structure 108 and 109 becomes less than 8% across the entire range of the 2nd period. Therefore, considering only the reflectance aspect, the target reflectance of this invention can be achieved without moving the total thickness period using the first layer 108a, and furthermore, the total THK (ta) at this situation is 47.5±1.5nm, so there is no shadowing effect problem. In FIG. 9, in the second embodiment, the reflectance (R) rises sharply when the thickness (Bot Ta THK) of the first layer 108a is 21nm or more. Therefore, to obtain a reflectance of less than 8%, in the second embodiment, the thickness (Bot Ta THK) of the first layer 108a is preferably less than 21nm. Even if the first layer 108a is extremely thin, a reflectance of less than 8% can be obtained, but if the thickness of the film is excessively thin, the mass productivity of the film decreases. Considering this, it is preferable that the first layer 108a has a thickness exceeding 2nm, which is the minimum thickness that can secure good mass productivity.

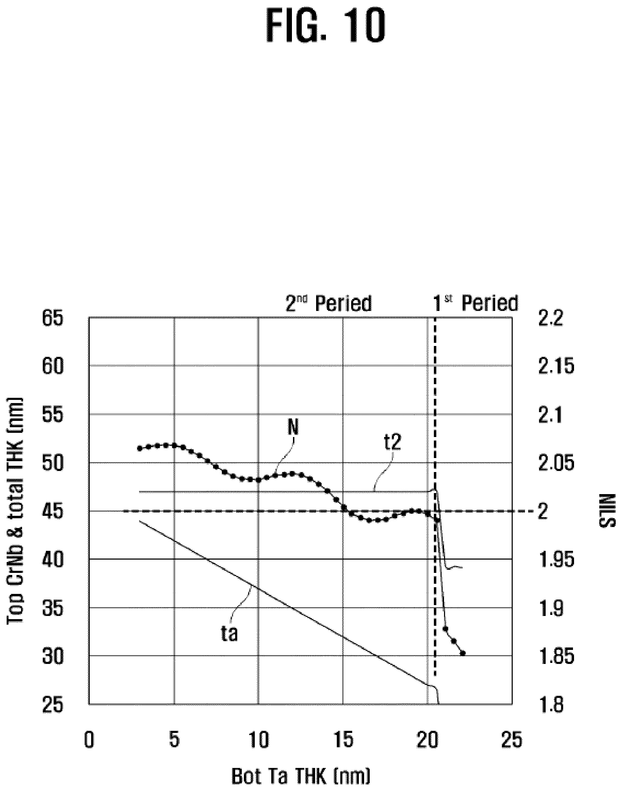

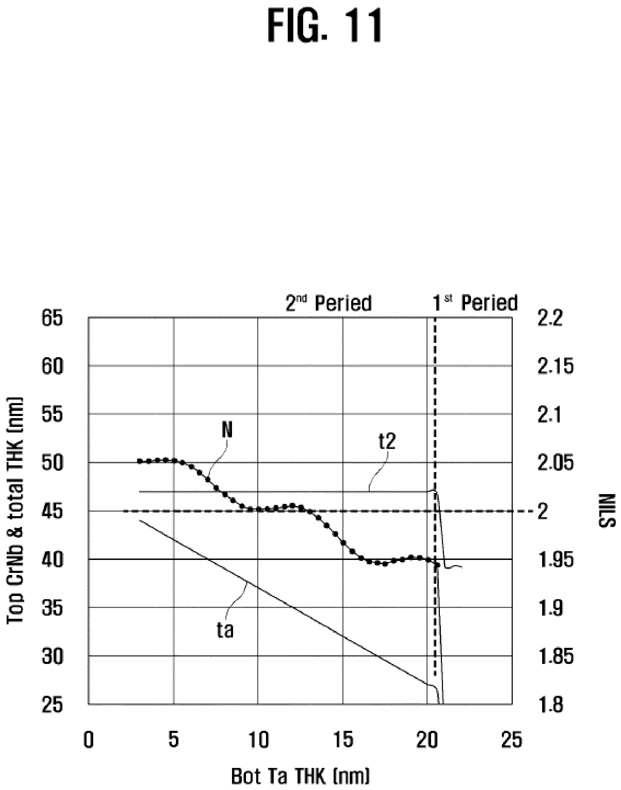

Referring to FIG. 10 and FIG. 11, the NILS of the stacked structure 108 and 109 in the horizontal and vertical directions deteriorates sharply when the first layer 108a is 21nm or more. Therefore, considering NILS, the thickness (Bot Ta THK) of the first layer 108a is also preferably less than 21nm. If the required NILS is 2.0 or more, considering the horizontal direction NILS in FIG. 10, a thickness of less than 15nm is possible, however, considering the vertical direction NILS in FIG. 11, it can be seen that it must be less than 13nm. Therefore, in cases where a good NILS of 2.0 or more is required, the first layer 108a preferably has a thickness of less than 13nm. Furthermore, it is confirmed through FIG. 10 and FIG. 11 that the NILS values in the horizontal and vertical directions can satisfy 2.05 or more when the first layer 108a has a thickness exceeding 3nm and less than 5nm. Therefore, in cases where an even better NILS of 2.05 or more is required, the first layer 108a preferably has a thickness exceeding 3nm and less than 5nm.

In the case of the second embodiment of this invention, since the extinction coefficient (k) of the second layer 108b of CrNb is relatively higher compared to the first embodiment, the thickness (Bot Ta THK) of the first layer 108a becomes relatively thinner. Accordingly, the second embodiment has the advantage that the total thickness (ta) of the phase shift film 108 can be thinner than the first embodiment. On the other hand, in the case of the first embodiment, the content of Cr in the second layer 108b of CrNb is less than in the second embodiment. Accordingly, the first embodiment has the advantage that the etching of the second layer 108b is easier than the second embodiment in the photomask manufacturing process. Furthermore, comparing FIG. 10 and FIG. 11 with FIG. 7 and FIG. 8, it can be seen that the first embodiment has a higher level of NILS compared to the second embodiment. Therefore, in cases where higher NILS is required, it is preferable that the first embodiment is adopted. In this way, considering various factors such as etching characteristics, thickness, and NILS, either the first embodiment or the second embodiment can be selected according to the application requirements of the photomask to be manufactured.

Meanwhile, as mentioned earlier, the first and second embodiments described above are examples assuming that the pattern of the hard mask film 109 containing TaO and having a thickness of 2nm on top of the phase shift film 108 remains in the photomask. Therefore, if the blankmask is formed without the hard mask film 109 itself, or if the hard mask film 109 is removed after etching the phase shift film 108 so that it does not remain in the photomask, the thickness (ta) of the phase shift film 108 in the explanation of the above embodiments should be increased compared to the previously described embodiments.

As explained above regarding the composition of the hard mask film 109, the hard mask film 109 must have a high content of oxygen (O) to be etched by fluorine-based etching gas, and accordingly, it has a low content of Ta, making its extinction coefficient (k) similar to that of the second layer 108b. Therefore, in the absence of the hard mask film 109, the target for increasing the thickness by that amount becomes the second layer 108b. That is, if the TaO hard mask film 109 is not formed or is formed but does not remain in the photomask, the thickness (t2) of the second layer 108b is increased from the values presented in the above embodiments as much as the thickness of the TaO hard mask film 109 that would remain. In summary, the thickness of the first layer 108a is the same as the values described for the first and second embodiments, and only the value of the total THK (ta), which is the sum of the thicknesses of the first layer 108a and the second layer 108b, increases by the thickness of the hard mask film 109. Specifically, in the absence of the hard mask film 109, the total THK (ta) becomes 55.5±1.5nm in the first embodiment and 49.5±1.5nm in the second embodiment. This applies to the case that the thickness of the hard mask film 109 is 2nm, but these values also apply to a thickness range of 2±1nm, considering the deviation in the manufacturing process of the hard mask film 109.

As a modification of this invention, an additional hard mask film (not shown) that is etched by chlorine-based etching gas can be formed on top of the hard mask film 109. As an example, the additional hard mask film can be formed of a material containing CrNb, preferably CrNbON. The TaO hard mask film 109 of this invention is etched by fluorine-based etching gas, and damage occurs to the resist film 110 during etching by fluorine-based etching gas. Therefore, the thickness of the resist film 110 must be increased for etching the TaO hard mask film 109. In cases where a thin resist film 110 is to be adopted, the thickness of the TaO hard mask film 109 must be thin, and in this case, the hard mask film 109 may be insufficient to be used as an etching mask for the phase shift film 108 below it. Adding a CrNbON hard mask film on top of the TaO hard mask film 109 can solve this problem. In this case, after patterning the CrNbON hard mask film with chlorine-based etching gas using the pattern of the resist film 110, the TaO hard mask film 109 is etched with fluorine-based etching gas. The pattern of the TaO hard mask film 109 and the pattern of the CrNbON hard mask film are used together as an etching mask for patterning the phase shift film 108. The pattern of the CrNbON hard mask film does not remain in the photomask and is removed. Since the phase shift film 108 is etched by chlorine-based etching gas, the pattern of the CrNbON hard mask film is removed during the etching process of the phase shift film 108. Therefore, the CrNbON hard mask film does not affect the configuration of the phase shift film 108 and the hard mask film 109 of this invention.

Although details of the disclosure have been described above through a few embodiments of the disclosure with reference to the accompanying drawings, the embodiments are merely for the illustrative and descriptive purposes only but not construed as limiting the scope of the disclosure defined in the appended claims. It will be understood by a person having ordinary skill in the art that various changes and other equivalent embodiments may be made from these embodiments. Thus, the scope of the invention should be defined by the technical subject matters of the appended claims.

## Claims

1. A phase shift blankmask for extreme ultraviolet lithography comprising:
a substrate;
a reflective film formed on the substrate;
a capping film formed on the reflective film; and
a phase shift film formed on the capping film,
wherein the phase shift film has a first layer formed on the capping film and a second layer formed on the first layer,
the first layer includes tantalum (Ta), has a Ta content exceeding 50at%, and has an extinction coefficient (k) exceeding 0.030,
the second layer includes chromium (Cr) and niobium (Nb), has a total content of Cr and Nb exceeding 50at%, has a composition ratio of Cr:Nb = 6.3:3.7 - 3.7:6.3, and has an extinction coefficient (k) exceeding 0.020,
the phase shift film has an effective extinction coefficient (eff. k) exceeding 0.022 for an EUV wavelength of 13.5nm in an entire film including the first layer and the second layer, and
the phase shift film has a relative reflectance of less than 8% for an EUV wavelength of 13.5nm.

2. The phase shift blankmask of claim 1, wherein the phase shift film has a relative reflectance exceeding 5%.

3. The phase shift blankmask of claim 1 or 2, wherein the second layer has a composition ratio of Cr:Nb = 4.3:5.7 - 3.7:6.3.

4. The phase shift blankmask of claim 3, wherein the first layer has a thickness exceeding 8nm and less than 21nm.

5. The phase shift blankmask of claim 3, wherein the first layer has a thickness exceeding 8nm and less than 13nm.

6. The phase shift blankmask of claim 3, wherein the first layer has a thickness exceeding 8nm and less than 10nm.

7. The phase shift blankmask of claim 1 or 2, wherein the second layer has a composition ratio of Cr:Nb = 6.3:3.7 - 5.7:4.3.

8. The phase shift blankmask of claim 7, wherein the first layer has a thickness exceeding 2nm and less than 21nm.

9. The phase shift blankmask of claim 7, wherein the first layer has a thickness exceeding 2nm and less than 13nm.

10. The phase shift blankmask of claim 7, wherein the first layer has a thickness exceeding 2nm and less than 5nm.

11. The phase shift blankmask of any one of claims 1 to 10, further comprising a hard mask film formed on the phase shift film, including tantalum (Ta) and oxygen (O), having a Ta content of less than 50at%, and having an extinction coefficient (k) exceeding 0.020.

12. The phase shift blankmask of claim 11, wherein the relative reflectance in a stacked structure including the phase shift film and the hard mask film is less than 8%.

13. The phase shift blankmask of claim 11 or 12, wherein the hard mask film has a thickness of 2±1nm.

14. The phase shift blankmask of any one of claims 1 to 13, wherein the first layer further includes one or more of boron (B) and nitrogen (N), and the second layer further includes one or more of boron (B), oxygen (O), and nitrogen (N).

15. A photomask fabricated using the phase shift blankmask for extreme ultraviolet lithography of any one of claims 1 to 14.
